# EUROPÄISCHE PATENTSCHRIFT

(11) **EP 1 840 682 B1**
(45) Veröffentlichungstag und Bekanntmachung des Hinweises auf die Patenterteilung: **25.01.2012**
(21) Anmeldenummer: 07005130.5
(22) Anmeldetag: 13.03.2007
(51) Int. Cl.: G05B 19/042

(54) **Elektrisches Feldgerät und Erweiterungsmodul zum Einstecken in das elektrisches Feldgerät**
Electrical field device and extension module for plugging in to said electric field device
Appareil de terrain électrique et module d'extension destiné à l'introduction dans l'appareil de terrain électrique

(30) Priorität: 22.03.2006 DE 102006013632; 19.06.2006 DE 102006028361
(43) Veröffentlichungstag der Anmeldung: 03.10.2007
(73) Patentinhaber: PHOENIX CONTACT GmbH & Co. KG, 32825 Blomberg (DE)
(72) Erfinder: Leifer, Christoph, 33014 Bad Driburg (DE); Korrek, Andre, 37696 Marienmünster (DE)
(74) Vertreter: Gesthuysen, von Rohr & Eggert

(56) Entgegenhaltungen:
- EP-A1- 0 499 675
- DE-A1- 10 161 401
- DE-A1-102004 025 484

## Beschreibung

Die Erfindung betrifft ein elektrisches Feldgerät zum Einsatz in der industriellen Steuerung, mit einem Gehäuse, mit mindestens einem Eingang, mindestens einem Ausgang und mit einer einen Mikrocontroller, einen Speicher und eine Leiterplatte aufweisenden elektronischen Schaltung, wobei an einer Seite des Gehäuses eine Öffnung zum Einstecken eines zumindest eine Leiterplatte aufweisenden elektronischen Erweiterungsmoduls ausgebildet ist und wobei die Leiterplatte des elektrischen Feldgeräts in einem Kontaktbereich Kontakte zur mechanischen und elektrischen Kontaktierung von mit der Leiterplatte des Erweiterungsmoduls verbundenen Gegenkontakten aufweist.. Daneben betrifft die Erfindung noch eine Geräteeinheit bestehend aus einem elektrischen Feldgerät und einem Erweiterungsmodul zum Einstecken in das elektrische Feldgerät, wobei das Erweiterungsmodul ein Gehäuse und eine eine Leiterplatte aufweisenden elektronischen Schaltung umfasst.

Elektrische Feldgeräte werden im Bereich der Automatisierung zur Steuerung von Anlagen und Maschinen in unterschiedlichen Varianten eingesetzt. Kernstück der Automatisierung ist dabei die Steuerung, die mit den einzelnen Sensoren und Aktoren, die den jeweiligen Prozeß überwachen, steuern und regeln kommuniziert. Für die reibungslose Kommunikation zwischen dem Prozeß und der Steuerung ist häufig eine Signalanpassung erforderlich, wozu entsprechende elektrische Geräte verwendet werden, die dabei aufgrund ihrer Anordnung auf der Feldseite als Feldgeräte bezeichnet werden Funktional können solche Feldgeräte auch allgemein als Signalkonverter bezeichnet werden, wobei die Signalkonverter beispielsweise für eine Signalanpassung von digitalen, analogen, seriellen oder Strom- bzw. Spannungssignalen zwischen der Feldseite und der Steuerungsseite sorgen. Die elektrischen Feldgeräte, die auch als Schnittstellenbausteine bezeichnet werden können, dienen dabei in der Regel auch der Potentialtrennung zwischen den verschiedenen Signalformen und Spannungsebenen der aufeinandertreffenden Signale. Die elektrischen Feldgeräte können daher auch zum Trennen, Verstärken oder Wandeln der einzelnen Signale dienen.

Im Rahmen der vorliegenden Erfindung werden unter elektrischen Feldgeräten neben den zuvor beschriebenen Schnittstellenbausteine bzw. Signalkonvertem insbesondere Relais-Schnittstellen in Form von elektromechanischen Last- oder Sicherheitsrelais und Optokoppler-Modulen sowie modulare Konverter für die Meß-, Steuer- und Regelungstechnik, wie beispielsweise Temperatur- oder Frequenzumsetzer, verstanden.

Wenn derartige elektrische Feldgeräte über eine Busleitung mit der übergeordneten Steuerung verbunden sind, kann die Konfiguration der Feldgeräte direkt über den Bus mittels der Steuerung erfolgen. Häufig kommt es jedoch vor, daß die elektrischen Feldgeräte als sogenannte "Stand-Alone-Geräte" eingesetzt werden, d. h. die Feldgeräte weisen entweder keinen Busanschluß auf oder sind nicht an einem Bus angeschlossen. Die Konfiguration derartiger Feldgeräte muß dann unmittelbar am Gerät selber erfolgen.

Bei einfachen Feldgeräten, welche nur eine begrenzte Funktionalität und somit auch nur eine begrenzte Anzahl an einzustellenden Parametern aufweisen, erfolgt die Konfiguration der Feldgeräte häufig mittels Drehkodierschaltern, Potentiometern oder DIP-Schaltern. Elektrische Feldgeräte mit einer höheren Komplexität weisen häufig ein Bedienteil mit einer Tastatur und einem Display zum Einstellen und Anzeigen der einzelnen Parameter auf. Aufgrund des in der Regel nur begrenzt zur Verfügung stehenden Platzes für die Tastatur und das Display stehen meist nur zwei oder drei Tasten zur Eingabe der einzelnen Parameter zur Verfügung, so daß eine vollständige Konfiguration des Feldgeräts sehr mühsam ist.

Aufgrund der steigenden Funktionalität der elektrischen Feldgeräte wird auch die Konfiguration der Feldgeräte immer komplexer, so daß eine Bedienung und Konfiguration mit Hilfe von direkt am Feldgerät angebrachten Bedienelementen sehr schwierig ist. Die immer weiter voranschreitende Miniaturisierung führt außerdem dazu, daß es unter praktikablen bzw. ergonomischen, Gesichtspunkten immer seltener möglich ist, die Bedienschnittstelle direkt am Feldgerät zu realisieren. In der Praxis erfolgt daher bei elektrischen Feldgeräten mit mittlerer oder hoher Komplexität die Konfiguration in der Regel mittels einer Bediensoftware, wozu die Feldgeräte jedoch mit einen Computer oder Laptop verbunden werden müssen.

Zusätzliche Probleme treten im Störungs- oder Servicefall auf, da dann entweder die Parameter mittels des Displays mühsam aus dem defekten Feldgerät ausgelesen oder der Anlagendokumentation entnommen und in ein neues Feldgerät übertragen werden müssen. Die Übertragung der Daten mittels einer Bediensoftware verringert zwar den Parametrieraufwand, erfordert jedoch die Verwendung eines Computers und in der Regel die Anwesenheit von entsprechend geschultem Personal.

Ein eingangs beschriebenes Feldgerät ist aus der WO 2006/013155 A1 bekannt. Bei dem bekannten Feldgerät sind innerhalb eines Gehäuses eine Mehrzahl von Gerätekomponenten in Form von Leiterplatteneinschüben angeordnet, wobei eine als Steuereinheit dienende Leiterplatte neben einem Rechenbaustein, elektronischen Bauteilen und einem fest eingebauten Speicherelement eine Schnittstelle für ein Erweiterungsmodul in Form eines entnehmbaren Speicherbausteins aufweist. Zur besseren Zugänglichkeit des entnehmbaren Speicherbausteins ist in einer Gehäuseseitenwand eine Öffnung vorgesehen, durch die der Speicherbaustein entnommen werden kann.

Die DE 10 2004 025 484 A1 offenbart ein Feldgerät für die Automatisierungstechnik, mit einem - nicht dargestellten - Gehäuse, mit einer Feldbusschnittstelle und mit einer eine Recheneinheit und mehrere Speicher aufweisenden elektronischen Schaltung, wobei davon ausgegangen werden kann, daß die elektronische Schaltung auf einer oder mehreren Leiterplatten angeordnet ist. Damit das bekannte Feldgerät einfach und kostengünstig für Standard-Schnittstellen geeignet ist, ist eine parallele Kommunikationsschnittstelle vorgesehen, die als Standard-Einschubfach für unterschiedliche Schnittstellenmodule ausgebildet ist.

Die DE 101 61 401 A1 offenbart ebenfalls ein Feldgerät zur Bestimmung und Überwachung einer Prozeßvariablen mit einem Meßwertaufnehmer und einer Feldgeräteelektronik, wobei die Feldgeräteelektronik eine Steuereinheit und ein herausnehmbares Speichermodul umfaßt. Das Speichermodul, welches neben einer Speichereinheit eine individuelle Kennung sowie Bedien- und Anzeigeelemente aufweist, ist zum Datenaustausch über eine Schnittstelle mit der Steuereinheit verbunden.

Der vorliegenden Erfindung liegt die Aufgabe zugrunde, bei einem eingangs beschriebenen elektrischen Feldgerät den Berührschutz auf einfache Art und Weise zu erhöhen.

Diese Aufgabe wird bei dem eingangs beschriebenen elektrischen Feldgerät dadurch gelöst, daß in der Leiterplatte des elektrischen Feldgeräts eine Aussparung derart ausgebildet ist, daß ein eingestecktes Erweiterungsmodul außer im Kontaktbereich keine leitende Verbindung mit dem Feldgerät aufweist wobei sich der Kontaktbereich in einer versenkten Einbaulage befindet, so daß eine sichere Potentialtrennung zwischen dem Geräteinneren und einem Anwender gewährleistet ist.

Es ist somit zunächst vorgesehen, daß das elektrische Feldgerät zur Aufnahme eines entsprechenden Erweiterungsmoduls eine Öffnung und zur elektrischen Kontaktierung des Erweiterungsmoduls einen entsprechenden Kontaktbereich aufweist. Das Erweiterungsmodul kann somit einfach durch die Öffnung im Gehäuse in das Feldgerät eingesteckt werden, wobei bei vollständigem Einstecken des Erweiterungsmoduls gleichzeitig die elektrische Kontaktierung erfolgt. Die Öffnung im Gehäuse des Feldgeräts ist dabei so ausgebildet, daß sich der Großteil eines eingesteckten Erweiterungsmoduls innerhalb des Gehäuses des Feldgeräts befindet. Wesentlich ist dabei, daß der elektrische Kontaktbereich zwischen der Leiterplatte des elektrischen Feldgeräts und der Leiterplatte des Erweiterungsmoduls soweit innerhalb des Gehäuses angeordnet ist, daß es nicht zu einer ungewollten Berührung der Kontaktelemente kommen kann.

Durch die in der Leiterplatte erfindungsgemäß ausgebildete Aussparung ist dabei gewährleistet, daß die von dem elektrischen Feldgerät realisierte Potentialtrennung zwischen der Eingangs- und der Ausgangsseite und insbesondere auch zwischen dem Geräteinneren und einem Anwender gewährleistet bleibt. Eine zusätzliche galvanische Trennung ist somit nicht erforderlich, so daß auch der schaltungstechnische Mehraufwand zur Realisierung des Kontaktbereichs innerhalb des elektrischen Feldgeräts gering ist.

Zuvor ist bereits ausgeführt worden, daß beim vollständigen Einschieben bzw. Einstecken des Erweiterungsmoduls in das elektrische Feldgerät automatisch eine Kontaktierung zwischen den Kontakten der Leiterplatte des Feldgeräts und den Gegenkontakten des Feldmoduls erfolgt. Hierzu weist die Leiterplatte im Kontaktbereich entweder eine Buchse zur Aufnahme entsprechender Steckkontakte oder Steckkontakte zum Einstecken in eine korrespondierende Buchse des Erweiterungsmoduls auf.

Vorzugsweise ist vorgesehen, daß das elektrische Feldgerät zur Aufnahme unterschiedlicher Erweiterungsmodule ausgebildet ist. Handelt es sich bei dem Erweiterungsmodul beispielsweise um einen Konfigurationsspeicher, so kann die Konfiguration des elektrischen Feldgeräts bei der Inbetriebnahme oder im Servicefall einfach dadurch erfolgen, daß ein entsprechendes Erweiterungsmodul in die Öffnung des Feldgeräts eingesteckt wird. Eine aufwendige Parametrierung von Hand oder die Verwendung eines Computers ist somit nicht erforderlich.

Ist das elektrische Feldgerät zur Aufnahme unterschiedlicher Erweiterungsmodule geeignet, so ist vorzugsweise vorgesehen, daß der in dem elektrischen Feldgerät vorhandene Mikrocontroller die Funktionalität des eingesteckten Erweiterungsmoduls selbständig erkennt. Die Erkennung der Art bzw. des Typs des eingesteckten Erweiterungsmoduls kann dabei beispielsweise anhand der Beschaltung der Gegenkontakte des Erweiterungsmoduls erfolgen. Insbesondere kommt hier eine Erkennung des oder der jeweiligen Gegenkontakte des Erweiterungsmoduls in Frage, der bzw. die mit dem Bezugspotential verbunden sind.

Wie zuvor bereits ausgeführt worden ist, ist aufgrund der vertieften Anordnung des Kontaktbereichs im Gehäuse des elektrischen Feldgeräts sowie der Ausbildung der Aussparung in der Leiterplatte des Feldgeräts die Ausbildung einer zusätzlichen galvanischen Trennung im Feldgerät nicht erforderlich. Zur Realisierung der elektrischen Verbindung mit dem Erweiterungsmodul sind daher vorzugsweise neben den Kontakten nur ein Widerstandsarray zur Terminierung und gegebenenfalls ein Diodenarray als Überspannungsschutz zwischen den Mikrocontroller und die Kontakte geschaltet.

Neben einem zuvor beschriebenen elektrischen Feldgerät betrifft die vorliegende Erfindung auch eine Geräteeinheit bestehend aus einem elektrischen Feldgerät und einem Erweiterungsmodul zum Einstecken in ein elektrisches Feldgerät, wobei das Erweiterungsmodul ein Gehäuse und eine in dem Gehäuse angeordnete Leiterplatte aufweist. Bei einer derartigen Geräteeinheit ist das Erweiterungsmodul erfindungsgemäß dadurch gekennzeichnet, daß die Leiterplatte an einer Stirnseite Gegenkontakte zur elektrischen Kontaktierung von mit der Leiterplatte des elektrischen Feldgeräts verbundenen Kontakten aufweist, wobei die Gegenkontakte derart von außerhalb des Gehäuses zugänglich sind, daß im eingesteckten Zustand des Erweiterungsmoduls außer im Bereich der Gegenkontakte keine leitende Verbindung mit dem Feldgerät besteht.

Wie zuvor bereits im Zusammenhang mit dem erfindungsgemäßen elektrischen Feldgerät ausgeführt worden ist, erfolgt die elektrische Kontaktierung des Erweiterungsmoduls mit dem Feldgerät automatisch bei vollständig eingestecktem Erweiterungsmodul. Hierzu weist die Leiterplatte des Erweiterungsmoduls entweder Steckkontakte zum Einstecken in eine Buchse des Feldgeräts oder eine Buchse zur Aufnahme der an der Leiterplatte des Feldgeräts ausgebildeten Steckkontakte auf.

Zur Sicherstellung der Potentialtrennung besteht das Gehäuse des Erweiterungsmoduls aus Kunststoff oder einem Kunststoffüberzug. Darüber hinaus ist die Leiterplatte mit Ausnahme der Gegenkontakte vollständig vom Gehäuse umschlossen, vorzugsweise sogar innerhalb des Gehäuses umspritzt bzw. vergossen.

Insbesondere dann, wenn das Erweiterungsmodul als Konfigurationsspeicher dient, weist es einen mit der Leiterplatte verbundenen Speicherbaustein, insbesondere einen EEPROM oder einen FLASH-Speicher auf. Bei einem als Konfigarationsspeicher dienenden Erweiterungsmodul handelt es sich dann um ein passives Erweiterungsmodul, welches nur dann reagiert, wenn es von dem als Master fungierenden Mikrocontroller des elektrischen Feldgeräts angesprochen wird. Durch eine entsprechende Verschaltung der Gegenkontakte des Erweiterungsmoduls und damit der Eingänge der Speicherbausteins, insbesondere des "MODE-Eingangs" wird das Erweiterungsmodul von dem Mikrocontroller als Konfigurationsspeicher erkannt, aus dessen Speicherbaustein der Mikrocontroller bei Bedarf die zur Konfiguration benötigten Daten ausliest.

Das Erweiterungsmodul kann außer als Konfigurationsspeicher beispielsweise auch zur Langzeitdatenaufzeichnung eingesetzt werden, wobei dann ein hierfür geeigneter Speicherbaustein, beispielsweise ein ferromagnetischer Speicher auf der Leiterplatte des Erweiterungsmoduls angeordnet ist.

Gemäß einer bevorzugten Ausgestaltung des Erweiterungsmoduls, insbesondere bei einer Ausgestaltung als Konfigurationsspeicher oder als Langzeitspeicher, ist auf der den Gegenkontakten gegenüberliegenden Seite des Gehäuses ein Beschriftungsfeld ausgebildet. Durch die Ausbildung eines Beschriftungsfeldes wird auf einfache Art und Weise die Gefahr einer Vertauschung eines als Konfigurationsspeicher ausgebildeten Erweiterungsmoduls verhindert. Das Beschriftungsfeld ist dabei vorzugsweise austauschbar, so daß das Erweiterungsmodul bei Bedarf- und nach entsprechender Programmierung - für ein beliebiges Feldgerät verwendet werden kann.

Neben der Ausgestaltung des Erweiterungsmoduls als Konfigurations- oder Langzeitspeicher kann das Erweiterungsmodul auch als Schnittstelle, insbesondere als Bluetooth-Schnittstelle oder als Adapter, insbesondere als USB-Adapter ausgebildet sein. Die Leiterplatte des Erweiterungsmoduls ist dann mit einem entsprechenden Transceiver oder mit einem Controller und einer entsprechenden Buchse bzw. einem entsprechenden Stecker verbunden.

Gemäß einer letzten Ausgestaltung, die hier noch kurz erwähnt werden soll, kann das Erweiterungsmodul auch als Bedienteil ausgebildet sein, wobei dann auf der den Kontakten gegenüberliegenden Seite des Gehäuses ein Bedienfeld mit mindestens einer Taste und/oder einem Display, insbesondere einer LCD-Anzeige angeordnet ist. Mit Hilfe eines derartigen als Bedienteil fungierenden Erweiterungsmoduls können dann auf einfache Art und Weise kleinere Änderungen der Konfiguration des elektrischen Feldgeräts schnell und einfach vor Ort vorgenommen werden. Weist das Bedienfeld ein Display auf, so können darüber hinaus mit dem Erweiterungsmodul einzelne Parameter und Funktionsdaten des Feldgeräts schnell und einfach vor Ort angezeigt werden.

Insgesamt gibt es eine Vielzahl von Möglichkeiten, das Erweiterungsmodul der erfindungsgemäßen Geräteeinheit auszugestalten und weiterzubilden. Unabhängig von den auf der Leiterplatte des Erweiterungsmoduls angeordneten elektronischen Bauteilen und unabhängig von der konkreten Ausgestaltung des Gehäuses des Erweiterungsmoduls ist dabei allen Erweiterungsmodulen gemeinsam, daß sie schnell und einfach durch Einstecken mit dem elektrischen Feldgerät verbunden werden können, wobei aufgrund der versenkten Einbaulage des Kontaktbereichs die Normen bezüglich der sicheren Trennung, die bis zu 8 mm Luftstrecke und Kriechstrecke fordern, eingehalten werden. Durch die Austauschbarkeit der Erweiterungsmodule kann ein elektrisches Feldgerät schnell und einfach unterschiedlichen Anforderungen angepaßt werden, ohne daß dazu unterschiedliche Feldgeräte oder aufwendige Veränderungen an einem Feldgerät erforderlich sind.

Im einzelnen gibt es nun eine Vielzahl von Möglichkeiten, das erfindungsgemäße elektrische Feldgerät bzw. die erfindungsgemäße Geräteeinheit auszugestalten und weiterzubilden. Hierzu wird verwiesen sowohl auf die den Patentansprüchen 1 und 8 nachgeordneten Patentansprüche, als auch auf die nachfolgende Beschreibung bevorzugter Ausführungsbeispiele anhand der Zeichnung. In der Zeichnung zeigen:
- Fig. 1: eine vereinfachte Darstellung eines ersten Ausführungsbeispiels eines elektrischen Feldgeräts mit eingestecktem Erweiterungs- modul, in Schnittdarstellung und in Draufsicht,
- Fig. 2: eine vereinfachte Darstellung eines zweiten Ausführungsbei- spiels eines elektrischen Feldgeräts mit einem eingesteckten Er- weiterungsmodul, in Schnittdarstellung und in Draufsicht,
- Fig. 3: eine vereinfachte Darstellung eines dritten Ausführungsbeispiels eines elektrischen Feldgeräts mit eingestecktem Erweiterungs- modul, in Schnittdarstellung,
- Fig. 4: eine perspektivische Darstellung eines in einem Gehäuse einge- steckten Erweiterungsmoduls,
- Fig. 5: das Erweiterungsmodul gemäß Fig. 4 in vergrößerter Darstel- lung, teilweise geschnitten,
- Fig. 6: ein weiteres Ausführungsbeispiel eines erfindungsgemäßen Er- weiterungsmoduls, teilweise geschnitten,
- Fig. 7: einen Schaltplan der elektrischen Verbindung von elektrischen Feldgerät und Erweiterungsmodul, und
- Fig. 8: einen Schaltplan eines Ausführungsbeispiels eines Erweiterungs- moduls.

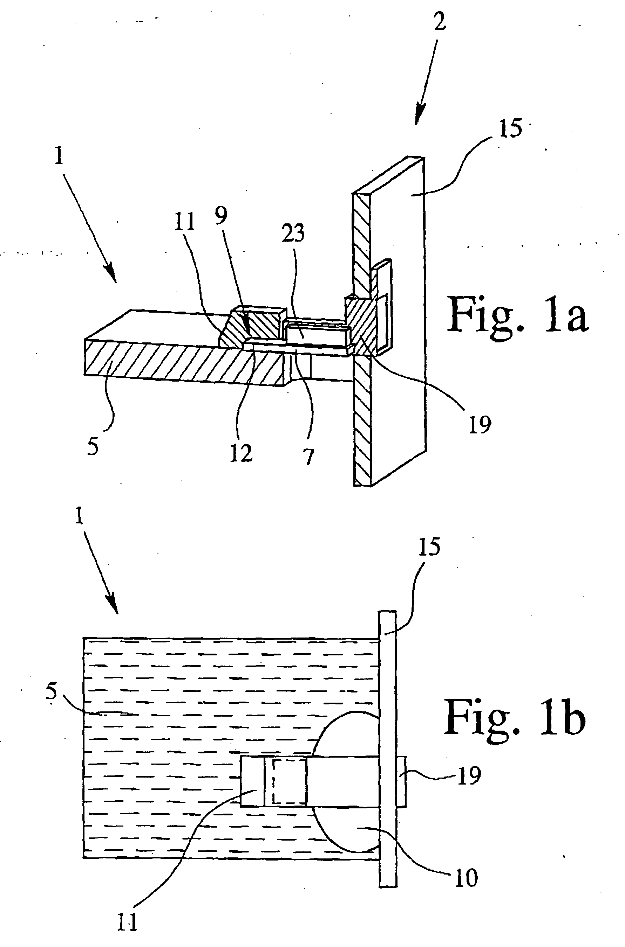

Die Fig. 1 bis 4 zeigen einen Ausschnitt eines elektrischen Feldgeräts 1 mit einem in den Figuren nur teilweise dargestellten Gehäuse 2, wobei innerhalb des Gehäuses 2 eine elektronische Schaltung angeordnet ist, die zumindest aus einem Mikrocontroller 3, einem Speicher 4 und einer Leiterplatte 5 besteht, wobei der Mikrocontroller 3 und der Speicher 4 beide auf der Leiterplatte angeordnet sind. Bei dem Speicher 4 kann es sich dabei insbesondere auch um den internen Speicher des Mikrocontrollers 3 handeln, so daß Mikrocontroller 3 und Speicher 4 nur funktional, nicht jedoch als zwei separate Bauteile vorhanden sein müssen. Darüber hinaus gehören zu der elektronischen Schaltung weitere, insbesondere auf der Leiterplatte 5 angeordnete, hier jedoch nicht dargestellte elektrische und elektronische Bauteile, die von der Funktion des Feldgeräts abhängig sind.

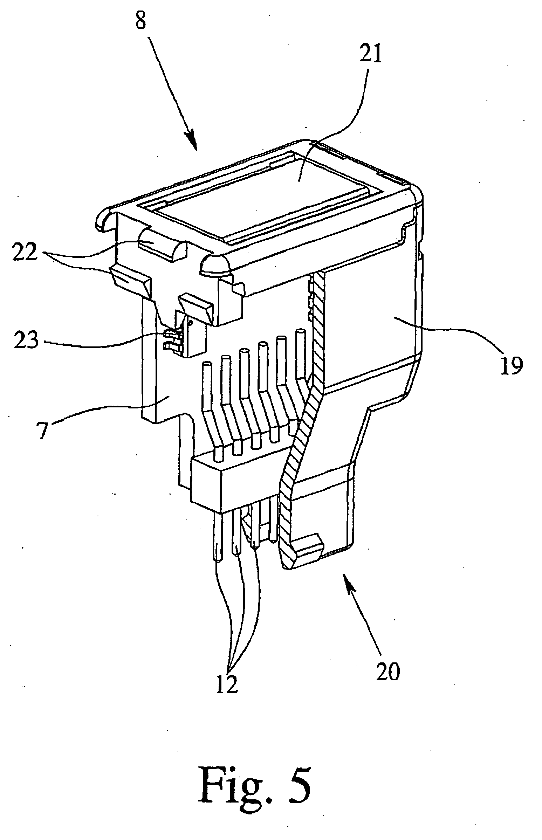

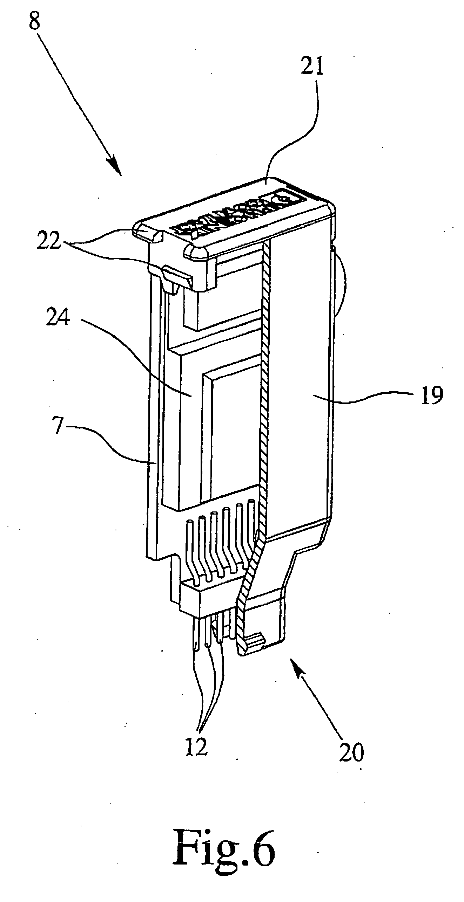

An einer Seite des hier nur teilweise dargestellten Gehäuses 2 ist eine Öffnung 6 ausgebildet, die zum Einstecken eines zumindest eine Leiterplatte 7 aufweisenden elektronischen Erweiterungsmoduls 8 dient. Ist das Erweiterungsmodul 8, von dem zwei verschiedene Ausführungsbeispiele insbesondere in den Fig. 5 und 6 dargestellt sind, vollständig in das Gehäuse 2 eingesteckt, so erfolgt eine elektrische Kontaktierung zwischen der Leiterplatte 5 des Feldgeräts 1 und der Leiterplatte 7 des Erweiterungsmoduls 8 innerhalb eines definierten Kontaktbereichs 9. Hierzu ist die Leiterplatte 5 des Feldgeräts 1 mit entsprechenden Kontakten und die Leiterplatte 7 des Erweiterungsmoduls 8 mit korrespondierenden Gegenkontakten verbunden.

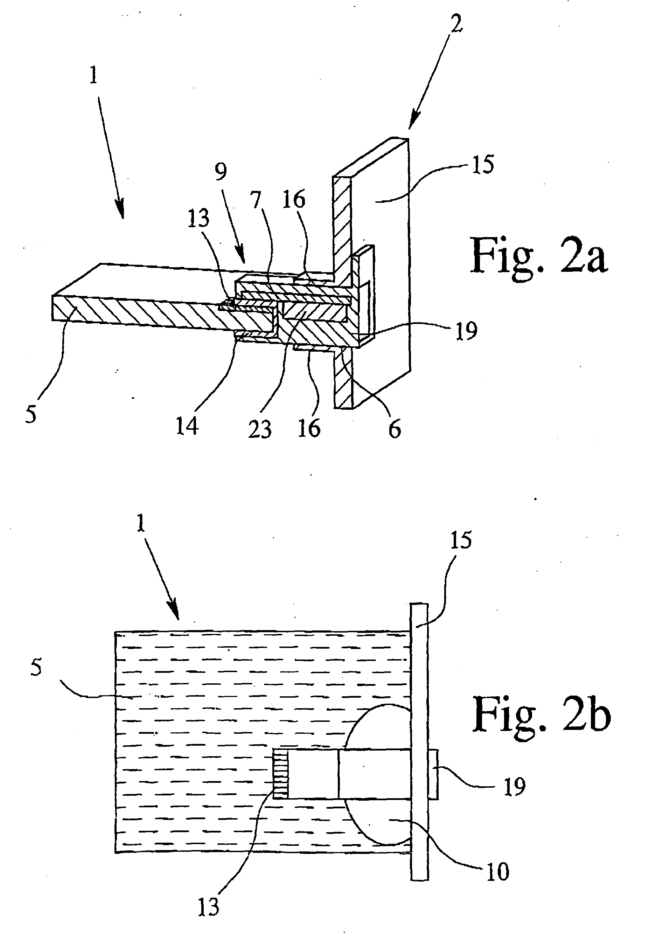

Wie insbesondere aus den beiden Draufsichten gemäß Fig. 1 b und Fig. 2 b ersichtlich ist, ist in der Leiterplatte 5 des Feldgeräts 1 eine im wesentlichen halbkreisförmige Aussparung 10 ausgebildet, durch deren Ausbildung und Anordnung gewährleistet ist, daß die Normen bezüglich sicherer Trennung, die gewisse Mindest-Luftstrecken und Mindest-Kriechstrecken fordern, eingehalten werden. Durch die Ausbildung der Aussparung 10 in der Leiterplatte 5 des Feldgeräts 1 und die nachfolgend noch genauer beschriebene Ausgestaltung des Erweiterungsmoduls 8 ist dabei sichergestellt, daß eine elektrisch leitende Verbindung zwischen dem Feldgerät 1 bzw. der Leiterplatte 5 und dem Erweiterungsmodul 8 bzw. dessen Leiterplatte 7 nur im Kontaktbereich 9 gegeben ist.

Die beiden in den Fig. 1 und 2 dargestellten Feldgeräte 1 bzw. Erweiterungsmodule 8 unterscheiden sich dadurch voneinander, daß bei dem Feldgerät 1 gemäß Fig. 1 die Leiterplatte 5 im Kontaktbereich 9 eine Buchse 1 und die Leiterplatte 7 des Erweiterungsmoduls 8 korrespondierende Steckkontakte 12 aufweist, die in die Buchse 11 eingesteckt werden können. Bei dem Ausführungsbeispiel gemäß Fig. 2 weist die Leiterplatte 5 des Feldgeräts 1 im Kontaktbereich 9 entsprechende Steckkontakte 13 auf, während dic Leiterplatte 7 des Erweiterungsmoduls 8 mit einer korrespondierenden Buchse 14 verbunden ist, in die die Steckkontakte 13 eingesteckt werden können. Die elektrische Verbindung zwischen der Leiterplatte 5 des Feldgeräts 1 und der Leiterplatte 7 des Erweiterungsmoduls 8 erfolgt somit jeweils durch eine SteckerBuchsen-Verbindung. Die Steckkontakte 12 bzw. 13 sind dabei als Platinendirektstecker auf der Oberseite der Leiterplatte 5 bzw- 7 ausgebildet, wobei die Steckkontakte 12, 13 vorzugsweise zumindest partiell vergoldet sind, um eine dauerhafte, sichere Kontaktierung zu gewährleisten.

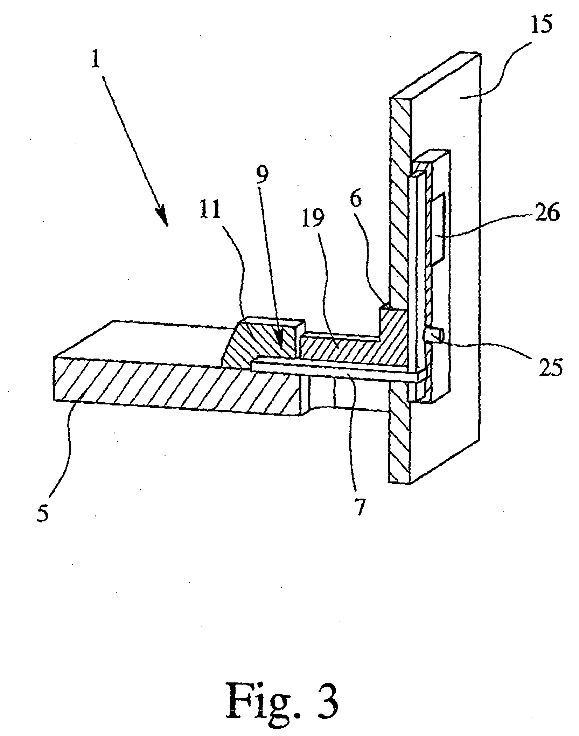

Bei der Seite des Gehäuses 2, in dem die Öffnung 6 ausgebildet ist, handelt es sich bei den dargestellten Ausführungsbeispielen um die Frontseite 15 des Gehäuses 2. Hierdurch ist die Öffnung 6 besonders einfach zugänglich, so daß auch das Einstecken eines Erweiterungsmoduls 8 besonders leicht durchgeführt werden kann. Bei den Ausführungsbeispielen gemäß den Fig. 1 und 3, bei denen die Leiterplatte 5 des Feldgeräts 1 eine Buchse 11 zur Aufnahme der Leiterplatte 7 des Erweiterungsmoduls 8 aufweist, übernimmt die Leiterplatte 5 zumindest teilweise auch die mechanische Führung und Abstützung des Erweiterungsmoduls 8. Bei dem Ausführungsbeispiel gemäß Fig. 2, bei dem an der Leiterplatte 7 des Erweiterungsmoduls 8 eine Buchse 14 ausgebildet ist, sind zur Führung des Erweiterungsmoduls 8 Führungsrippen 16 an der Frontseite 15 des Gehäuses 2 angeordnet, die sich ins Innere des Gehäuses 2 erstrecken. Entsprechende Führungsrippen 16 können selbstverständlich auch bei den Ausführungsbeispielen gemäß den Fig. 1 und 3 ausgebildet sein.

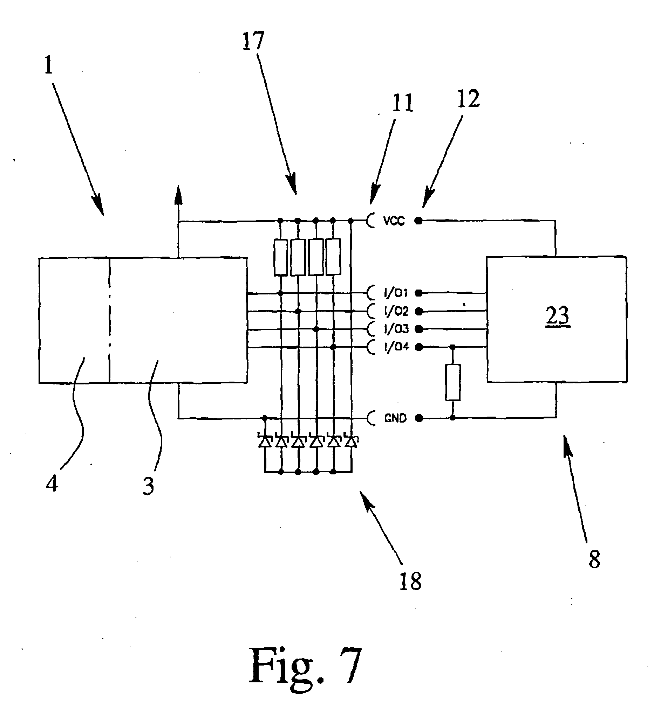

Fig. 7 zeigt ein vereinfachtes Schaltbild des elektrischen Aufbaus des Feldgeräts 1 und eines Erweiterungsmoduls 8, wobei hier - insbesondere bezüglich des Feldgeräts 1 - nur der Teil der Schaltung dargestellt ist, der der elektrischen Kontaktierung des Feldgeräts 1 bzw. dessen Mikrocontrollers 4 mit dem Erweiterungsmodul 8 dient. Zu der elektrischen Schaltung des Feldgeräts 1 gehören zunächst der Mikrocontroller 3 mit seinem internen Speicher 4. Über entsprechende, auf der Leiterplatte 5 ausgebildete Leiterbahnen sind die Eingänge des Mikrocontrollers 3 mit den als Buchsen 11 ausgebildeten Kontakten verbunden, die als Platinendirektstecker auf der Oberseite der Leiterplatte 5 ausgebildet sind. Zwischen dem Mikrocontroller 3 und den Buchsen 11 ist ein Widerstandsarray 17 zur Terminierung der Eingänge des Mikrocontrollers 3 geschaltet. Darüber hinaus weist die Schaltung auch ein Diodenarray 18 auf, welches als Überspannungsschutz für den Mikrocontroller 3 dient.

Über die Kontakte V_{CC} und GND der Leiterplatte 5 bzw. des Mikrocontrollers 3 wird das Erweiterungsmodul 8 mit der von ihm benötigten Betriebsspannung versorgt. Je nach Ausgestaltung des Erweiterungsmoduls 8 sind die als Steckkontakte 12 ausgebildeten Gegenkontakte des Erweiterungsmodul 8 unterschiedlich beschaltet, so daß der Mikrocontroller 3 das Feldgeräts 1 anhand der Beschaltung der Steckkontakte 12 den Typ des angeschlossenen Erweiterungsmoduls 8 erkennen kann. Die Unterscheidung der einzelnen Erweiterungsmodule 8 erfolgt dabei insbesondere anhand des Musters der mit dem Bezugspotential oder dem Erdpotential GND verbundenen Gegenkontakte des Erweiterungsmoduls 8.

Der mechanische Aufbau des Erweiterungsmoduls 8 ist insbesondere anhand der Fig. 5 und 6 erkennbar. Das Erweiterungsmodul 8 weist ein Gehäuse 19 auf, in dem die Leiterplatte 7 gehalten ist. Die Leiterplatte 7 ist dabei derart in dem Gehäuse 19 angeordnet, das lediglich die hier als Steckkontakte 12 ausgebildeten Gegenkontakte aus einer Stirnseite 20 des Gehäuses 19 herausragen bzw. von der Stirnseite 20 des Gehäuses 20 her zugänglich sind. Entsprechendes gilt natürlich auch für den Fall, daß auf der Leiterplatte 7 eine Buchse 14 angeordnet ist. Zur sicheren Isolierung der innerhalb des Gehäuses 19 angeordneten Leiterplatte 7 kann die Leiterplatte 7 in dem aus Kunststoff bestehenden Gehäuse umspritzt bzw. vergossen sein.

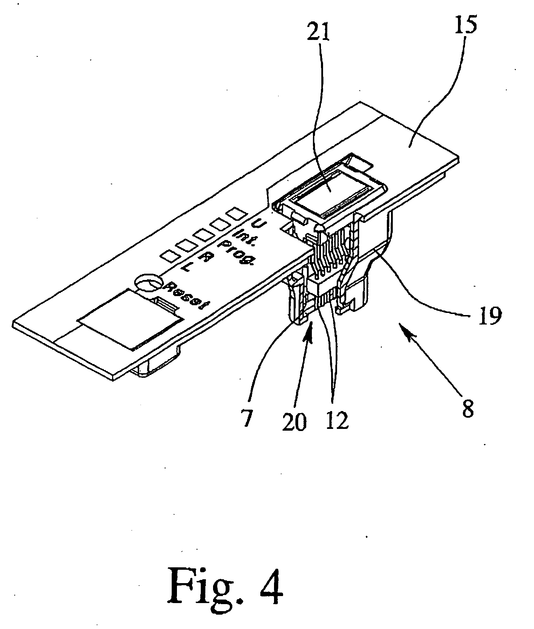

Auf der der Stirnseite 20 gegenüberliegenden Seite des Gehäuses 19 ist bei den in den Fig. 4 - 6 dargestellten Ausführungsbeispielen eines Erweiterungsmoduls 8 ein Beschriftungsfeld 21 angeordnet. Darüber hinaus weist das Gehäuse 19 an der der Stirnseite 20 gegenüberliegenden Seite des Gehäuses 19 mehrere Rastnasen 22 auf, mittels derer das Erweiterungsmodul 8 innerhalb der Öffnung 6 in der Frontseite 15 des elektrischen Feldgeräts 1 befestigt werden kann.

Das in Fig. 5 dargestellte Erweiterungsmodul 8 hat die Funktion eines Konfigurationsspeichers, so daß auf der Leiterplatte 7 ein entsprechender Speicherbaustein 23 angeordnet ist. Eine entsprechende Beschaltung eines derartigen Erweiterungsmoduls 8 ist in Fig. 7 dargestellt. Das Erweiterungsmodul 8 ist hierbei ein passives Modul, das nur dann reagiert, wenn es von dem als Master fungierenden Mikrocontroller 3 des elektrischen Feldgeräts 1 angesprochen wird. Vorzugsweise erfolgt dabei dann die Datenübertragung bidirektional über eine Verbindungsleitung zwischen dem Mikrocontroller 3 und dem Speicherbaustein 23.

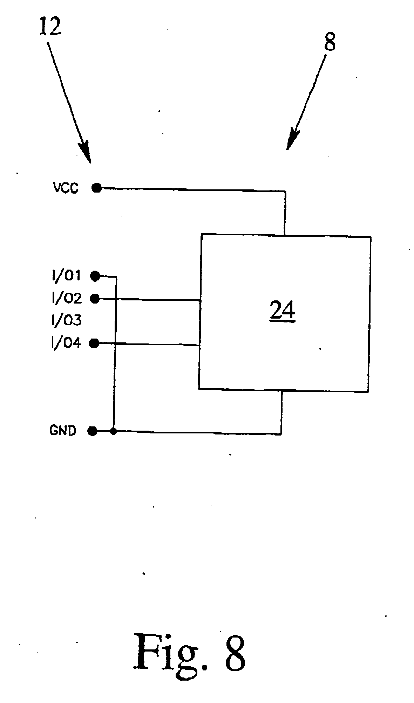

Das Erweiterungsmodul 8 gemäß Fig. 6 hat die Funktion einer Schnittstelle, insbesondere einer Bluetooth-Schnittstelle, wozu auf der Leiterplatte 7 ein entsprechender Transceiver 24 angeordnet ist. Die zugehörige Beschaltung eines derartigen Erweiterungsmoduls 8 ist in Fig. 8 gezeigt. Ein derartiges Erweiterungsmodul 8 übernimmt nun die Funktion eines Masters, d. h. es initiiert den Datenaustausch mit dem Mikrocontroller 3 des elektrischen Feldgeräts 1. Der Datenaustausch erfolgt dabei vorzugsweise unidirektional über zwei Datenleitungen zwischen den Eingängen des Mikrocontrollers 3 und den entsprechenden Eingängen des Transceivers 24. Anstelle eines Transceivers 24 kann ein derartiges Erweiterungsmodul 8 auch einen Controller aufweisen, so daß ein derartiges Erweiterungsmodul 8 auch als Adapter, beispielsweise als USB-Adapter verwendet werden kann. In diesem Fall ist die Leiterplatte 7 auf der der Stirnseite 20 gegenüberliegenden Seite mit einer weiteren Buchse, beispielsweise einer USB-Buchse oder direkt mit einem Kabel verbunden.

Fig. 3 zeigt schließlich ein Ausführungsbeispiel eines Erweiterungsmoduls 8, welches als Bedienteil ausgebildet ist. Auf der der Stirnseite 20 gegenüberliegenden Seite des Gehäuses 19 weist dieses Erweiterungsmodul 8 ein Bedienfeld mit zwei Tasten 25 und einem Display 26 auf. Über die Tasten 25 und das Display 26 können dabei einzelne Parameter des elektrischen Feldgeräts eingestellt und/oder angezeigt werden.

## Patentansprüche

1. Elektrisches Feldgerät zum Einsatz in der industriellen Steuerung, mit einem Gehäuse (2), mit mindestens einem Eingang, mindestens einem Ausgang und mit einer einen Mikrocontroller (3), einen Speicher (4) und eine Leiterplatte (5) aufweisenden elektronischen Schaltung,
wobei an einer Seite des Gehäuses (2) eine Öffnung (6) zum Einstecken eines zumindest eine Leiterplatte (7) aufweisenden elektronischen Erweiterungsmoduls (8) ausgebildet ist und
wobei die Leiterplatte (5) des elektrischen Feldgeräts (1) in einen Kontaktbereich (9) Kontakte zur mechanischen und elektrischen Kontaktierung von mit der Leiterplatte (7) des Erweiterungsmoduls (8) verbundenen Gegenkontakten aufweist,
**dadurch gekennzeichnet,**
**daß** in der Leiterplatte (5) des elektrischen Feldgeräts (1) eine Aussparung (10) derart ausgebildet ist, daß ein eingestecktes Erweiterungsmodul (8) außer im Kontaktbereich (9) keine leitende Verbindung mit dem Feldgerät (1) aufweist,
wobei sich der Kontaktbereich (9) in einer versenkten Einbaulage befindet, so daß eine sichere Potentialtrennung zwischen dem Geräteinneren und einem Anwender gewährleistet ist.

2. Elektrisches Feldgerät nach Anspruch 1, **dadurch gekennzeichnet, daß** die Leiterplatte (5) im Kontaktbereich (9) eine Buchse (11) zur Aufnahme von mit der Leiterplatte (7) des Erweiterungsmoduls (8) verbundenen Steckkontakten (12) aufweist.

3. Elektrisches Feldgerät nach Anspruch 1, **dadurch gekennzeichnet, daß** die Leiterplatte (5) im Kontaktbereich (9) Steckkontakte (13) zum Einstecken in eine mit der Leiterplatte (7) des Erweiterungsmoduls (8) verbundene Buchse (14) aufweist.

4. Elektrisches Feldgerät nach einem der Ansprüche 1 bis 3, **dadurch gekennzeichnet, daß** die Öffnung (6) zum Einstecken des elektronischen Erweiterungsmoduls (8) in der Frontseite (15) des Gehäuses (2) angeordnet ist, und daß vorzugsweise an der Frontseite (15) ins Innere des Gehäuses (2) ragenden Führungsrippen (16) oder Führungsschienen zur mechanischen Halterung und Führung eines einzuschiebenden Erweiterungsmoduls (8) ausgebildet sind.

5. Elektrisches Feldgerät nach einem der Ansprüche 1 bis 4, **dadurch gekennzeichnet, daß** der Mikrocontroller (3) die Funktionalität des eingesteckten Erweiterungsmoduls (8) selbstständig erkennt.

6. Elektrisches Feldgerät nach Anspruch 5, **dadurch gekennzeichnet, daß** der Mikrocontroller (3) das eingesteckte Erweiterungsmodul (8) anhand der Beschaltung, der Gegenkontakte des Erweiterungsmoduls (8) erkennt.

7. Elektrisches Feldgerät nach einem der Ansprüche 1 bis 6, **dadurch gekennzeichnet, daß** der Mikrocontroller (3) über ein Widerstandsarray (17) und vorzugsweise auch über ein Diodenarray (18) mit den Kontakten verbunden ist.

8. Geräteeinheit bestehend aus einem elektrischen Feldgerät (1) nach einem der Ansprüche 1 bis 7 und einem Erweiterungsmodul zum Einstecken in das elektrische Feldgerät, wobei das Erweiterungsmodul ein Gehäuse (19) und eine eine Leiterplatte (7) aufweisende elektronischen Schaltung umfasst,
**dadurch gekennzeichnet,**
**daß** die Leiterplatte (7) an einer Stirnseite (20) Gegenkontakte zur elektrischen Kontaktierung von mit der Leiterplatte (5) des elektrisches Feldgeräts (1) verbundenen Kontakten aufweist, wobei die Gegenkontakte derart von außerhalb des Gehäuses (19) zugänglich sind, daß im eingesteckten Zustand des Erweiterungsmoduls (8) außer im Bereich der Gegenkontakte keine leitende Verbindung mit dem Feldgerät (1) besteht.

9. Geräteeinheit nach Anspruch 8, **dadurch gekennzeichnet, daß** das Gehäuse (19) aus Kunststoff besteht und die Leiterplatte (7) mit Ausnahme der Gegenkontakte vom Gehäuse (19) umschlossen und vorzugsweise umspritzt oder vergossen ist.

10. Geräteeinheit nach Anspruch 8 oder 9, **dadurch gekennzeichnet, daß** die Gegenkontakte als Steckkontakte (12) zum Einstecken in eine mit der Leiterplatte (5) des e-lektrischen Feldgeräts (1) verbundenen Buchse (11) ausgebildet sind.

11. Geräteeinheit nach Anspruch 8 oder 9, **dadurch gekennzeichnet, daß** die Leiterplatte (7) eine Buchse (14) zur Aufnahme von an der Leiterplatte (5) des elektrischen Feldgeräts (1) ausgebildeten Steckkontakten (13) aufweist.

12. Geräteeinheit nach einem der Ansprüche 8 bis 11, **dadurch gekennzeichnet, daß** auf der den Gegenkontakten gegenüberliegenden Seite des Gehäuses (19) ein Beschriftungsfeld (21) ausgebildet ist.

13. Geräteeinheit nach einem der Ansprüche 8 bis 12, **dadurch gekennzeichnet, daß** die Leiterplatte (7) mit einem Speicherbaustein (23), insbesondere einem EEPROM, einem FLASH Speicher oder einem ferromagnetischen Speicher (FRAM) verbunden ist, so daß das Erweiterungsmodul (8) die Funktion eines Konfigurationsspeichers oder eines Langzeitspeichers aufweist.

14. Geräteeinheit nach einem der Ansprüche 8 bis 12, **dadurch gekennzeichnet, daß** die Leiterplatte (7) mit einem Transceiver (24), insbesondere einem Bluetooth-Transceiver verbunden ist, so daß das Erweiterungsmodul (8) die Funktion einer Schnittstelle, insbesondere einer Bluetooth-Schnittstelle aufweist.

15. Geräteeinheit nach einem der Ansprüche 8 bis 12, **dadurch gekennzeichnet, daß** die Leiterplatte (7) mit einem Controller und auf der den Gegenkontakten gegenüberliegenden Seite mit einer Buchse, insbesondere einer USB-Buchse verbunden ist, so daß das Erweiterungsmodul (8) die Funktion eines Adapters, insbesondere eines USB-Adapters aufweist.

16. Geräteeinheit nach einem der Ansprüche 8 bis 15, **dadurch gekennzeichnet, daß** auf der den Gegenkontakten gegenüberliegenden Seite des Gehäuses (19) ein Bedienfeld mit mindestens einer Taste (25) und/oder einem Display (26), insbesondere einer LCD-Anzeige angeordnet ist.

## Claims

1. Electrical field device for use in industrial control, having a housing (2), at least one input, at least one output, and an electronic circuit which has a microcontroller (3), a memory (4) and a circuit board (5),
wherein an opening (6) is formed on one side of the housing (2) for insertion of an electronic expansion module (8) which has at least one circuit board (7),
wherein the circuit board (5) of the electronic field device (1) has contacts in a contact region (9) for mechanical and electrical contact-making with mating contacts connected to the circuit board (7) of the expansion module (8),
**characterized in**
**that** a recess (10) is formed in the circuit board (5) of the electronic field device (1) such that an inserted expansion module (8) does not have any conductive connection to the field device (1) except in the contact region (9),
wherein the contact region (9) is located in a recessed mounting position, so that reliable electrical isolation between the interior of the device and the user is ensured.

2. Electrical field device according to claim 1, **characterized in that** the circuit board (5) has a socket (11) in the contact region (9) for holding plug-in contacts (12) which are connected to the circuit board (7) of the expansion module (8).

3. Electrical field device according to claim 1, **characterized in that** the circuit board (5) has plug-in contacts (13) in the contact region (9) for insertion into a socket (14) which is connected to the circuit board (7) of the expansion module (8).

4. Electrical field device according to any one of claims 1 to 3, **characterized in that** the opening (6) for inserting the electronic expansion module (8) is located in a front (15) of the housing (2), and preferably, there are guide ribs (16) or rails on the front (15) which extend into the interior of the housing (2) for mechanically holding and guiding an expansion module (8) during insertion thereof.

5. Electrical field device according to any one of claims 1 to 4, **characterized in that** the microcontroller (3) automatically detects the type of functionality of the inserted expansion module (8).

6. Electrical field device according to claim 5, **characterized in that** the microcontroller (3) automatically detects the inserted expansion module (8) based on a wiring of the mating contacts of the expansion module (8).

7. Electrical field device according to any one of claims 1 to 6, **characterized in that** the microcontroller (3) is connected to the contacts via a resistor array (17) and preferably also via a diode array (18).

8. Hardware unit consisting of an electrical field device (1) according to any one of claims 1 to 7, and an expansion module (8) for insertion into the electrical field device, wherein the expansion module includes a housing (19) and an electronic circuit which has a circuit board (7),
**characterized in**
**that** the circuit board (7) has mating contacts on an end face (20) for making electrical contact with contacts which are connected to the circuit board (5) of the electrical field device (1), the mating contacts are accessible from outside of the housing (19) such that, in an inserted state of the expansion module (8), there is no conductive connection to the field device (1) except in the region of the mating contacts.

9. Hardware unit according to claim 8, **characterized in that** the housing (19) is made of plastic, and the circuit board (7) is surrounded by the housing (19) except for the mating contacts, preferably the circuit board is molded or potted.

10. Hardware unit according to claim 8 or 9, **characterized in that** the mating contacts are plug-in contacts (12) for insertion into a socket (11) connected to the circuit board (5) of the electrical field device (1).

11. Hardware unit according to claim 8 or 9, **characterized in that** the circuit board (7) has a socket (14) for holding plug-in contacts (13) of the circuit board (5) of the electrical field device (1).

12. Hardware unit according to any one of claims 1 to 8, **characterized in that** an inscription field (21) is provided on an end of the housing (19) opposite the mating contacts.

13. Hardware unit according to any one of claims 8 to 12, **characterized in that** the circuit board (7) is connected to a memory module (23), in particular an EEPROM, a FLASH memory or a ferroelectric memory (FRAM), so that the expansion module (8) is adapted to function as a configuration memory or as a long term memory.

14. Hardware unit according to any one of claims 8 to 12, **characterized in that** the circuit board (7) is connected to a transceiver (24), in particular a bluetooth transceiver, so that the expansion module (8) is adapted to function as an interface, in particular as a bluetooth interface.

15. Hardware unit according to any one of claims 8 to 12, **characterized in that** the circuit board (7) is connected to the controller and to a socket on an end opposite the mating contacts, in particular a USB socket, so that the expansion module is able to function as an adapter, in particular as a USB adapter.

16. Hardware unit according to any one of claims 8 to 15, **characterized in that** on an end of the housing (19) opposite the mating contacts, there is a control panel with at least one key (25) and/or a display (26), in particular an LCD display.

## Revendications

1. Appareil de terrain électrique destiné à être utilisé en contrôle industriel, comprenant un boîtier (2) ayant au moins une entrée, au moins une sortie et avec un circuit électronique présentant un microcontrôleur (3), une mémoire (4) et un circuit imprimé (5),
une ouverture (6) pour enficher un module d'extension électronique (8) qui présente au moins un circuit imprimé (7) étant formée sur un côté du boîtier (2) et
le circuit imprimé (5) de l'appareil de terrain électrique (1) présentant dans une zone de contact (9) des contacts pour la mise en contact mécanique et électrique de contacts homologues reliés avec le circuit imprimé (7) du module d'extension (8),
**caractérisée en ce**
**qu'**un évidement (10) est formé dans le circuit imprimé (5) de l'appareil de terrain électrique (1) de telle sorte qu'un module d'extension (8) enfiché ne présente aucune liaison conductrice avec l'appareil de terrain (1) ailleurs que dans la zone de contact (9),
la zone de contact (9) se trouvant dans une position de montage noyée, ce qui permet de garantir une isolation sécurisée des potentiels entre l'intérieur de l'appareil et un utilisateur.

2. Appareil de terrain électrique selon la revendication 1, **caractérisé en ce que** le circuit imprimé (5) présente dans la zone de contact (9) une douille (11) pour accueillir des contacts enfichables (12) reliés avec le circuit imprimé (7) du module d'extension (8).

3. Appareil de terrain électrique selon la revendication 1, **caractérisé en ce que** le circuit imprimé (5) présente dans la zone de contact (9) des contacts enfichables (13) destinés à être insérés dans une douille (14) reliée avec le circuit imprimé (7) du module d'extension (8).

4. Appareil de terrain électrique selon l'une des revendications 1 à 3, **caractérisé en ce que** l'ouverture (6) pour enficher le module d'extension (8) électronique est disposée dans la face avant (15) du boîtier (2) et **en ce que** des nervures de guidage (16) ou des rails de guidage faisant saillie de préférence sur la face avant (15) à l'intérieur du boîtier (2) sont configurés pour le maintien et le guidage mécaniques d'un module d'extension (8) à enficher.

5. Appareil de terrain électrique selon l'une des revendications 1 à 4, **caractérisé en ce que** le microcontrôleur (3) reconnaît automatiquement la fonctionnalité du module d'extension (8) enfiché.

6. Appareil de terrain électrique selon la revendication 5, **caractérisé en ce que** le microcontrôleur (3) reconnaît le module d'extension (8) enfiché au moyen de la connexion des contacts homologues du module d'extension (8).

7. Appareil de terrain électrique selon l'une des revendications 1 à 6, **caractérisé en ce que** le microcontrôleur (3) est relié avec les contacts par le biais d'un réseau de résistances (17) et de préférence également par le biais d'un réseau de diodes (18).

8. Unité d'appareillage composée d'un appareil de terrain électrique (1) selon l'une des revendications 1 à 7 et d'un module d'extension à enficher dans l'appareil de terrain électrique, le module d'extension comprenant un boîtier (19) et un circuit électrique présentant un circuit imprimé (7),
**caractérisée en ce**
**que** le circuit imprimé (7) présente sur un côté frontal (20) des contacts homologues pour la mise en contact électrique avec les contacts reliés avec le circuit imprimé (5) de l'appareil de terrain électrique (1), les contacts homologues étant accessibles depuis l'extérieur du boîtier (19) de telle sorte que lorsque le module d'extension (8) est en position enfichée, il n'existe aucune liaison conductrice avec l'appareil de terrain (1) ailleurs que dans la zone des contacts homologues.

9. Unité d'appareillage selon la revendication 8, **caractérisée en ce que** le boîtier (19) est constitué de matière plastique et le circuit imprimé (7), à l'exception des contacts homologues, est entouré par le boîtier (19) et de préférence surmoulé ou enrobé.

10. Unité d'appareillage selon la revendication 8 ou 9, **caractérisée en ce que** les contacts homologues sont réalisés sous la forme de contacts enfichables (12) destinés à être insérés dans une douille (11) reliée avec le circuit imprimé (5) de l'appareil de terrain électrique (1).

11. Unité d'appareillage selon la revendication 8 ou 9, **caractérisée en ce que** le circuit imprimé (7) présente une douille (14) pour accueillir des contacts enfichables (13) formés sur le circuit imprimé (5) de l'appareil de terrain électrique (1).

12. Unité d'appareillage selon l'une des revendications 8 à 11, **caractérisée en ce qu'**un champ de marquage (21) est configuré sur le côté du boîtier (19) opposé aux contacts homologues.

13. Unité d'appareillage selon l'une des revendications 8 à 12, **caractérisée en ce que** le circuit imprimé (7) est relié avec un composant de mémoire (23), notamment une EEPROM, une mémoire FLASH ou une mémoire ferromagnétique (FRAM), de sorte que le module d'extension (8) présente la fonction d'une mémoire de configuration ou d'une mémoire permanente.

14. Unité d'appareillage selon l'une des revendications 8 à 12, **caractérisée en ce que** le circuit imprimé (7) est relié avec un émetteur/récepteur (24), notamment un émetteur/récepteur Bluetooth, de sorte que le module d'extension (8) présente la fonction d'une interface, notamment d'une interface Bluetooth.

15. Unité d'appareillage selon l'une des revendications 8 à 12, **caractérisée en ce que** le circuit imprimé (7) est relié avec un contrôleur et, sur le côté à l'opposé des contacts homologues, avec une douille, notamment une douille USB, de sorte que le module d'extension (8) présente la fonction d'un adaptateur, notamment d'un adaptateur USB.

16. Unité d'appareillage selon l'une des revendications 8 à 15, **caractérisée en ce que** sur le côté du boîtier (19) à l'opposé des contacts homologues est disposée une zone de commande comprenant au moins une touche (25) et/ou un afficheur (26), notamment un afficheur LCD.
